# EUROPÄISCHE PATENTSCHRIFT

(11) **EP 1 907 192 B1**
(45) Veröffentlichungstag und Bekanntmachung des Hinweises auf die Patenterteilung: **19.11.2008**
(21) Anmeldenummer: 06752584.0
(22) Anmeldetag: 29.06.2006
(51) Int. Cl.: B29C 67/00, G03F 7/027, C08F 2/48

(54) **RAPID-PROTOTYPING-VERFAHREN UND VERWENDUNG IN DIESEM VERFAHREN EINER STRAHLUNGSHÄRTBAREN ZUSAMMENSETZUNG**
RAPID-PROTOTYPING METHOD AND USE IN THE METHOD OF A RADIATION-HARDENABLE COMPOSITION
PROCEDE DE PROTOTYPAGE RAPIDE ET UTILISATION DANS CE PROCEDE D'UNE COMPOSITION POUVANT ETRE DURCI PAR RAYONNEMENT

(30) Priorität: 30.06.2005 AT 11062005
(43) Veröffentlichungstag der Anmeldung: 09.04.2008
(73) Patentinhaber: Technische Universität Wien, 1040 Wien (AT)
(72) Erfinder: STAMPFL, Jürgen, 1040 Wien (AT); GRUBER, Heinrich, 1190 Wien (AT); LICHTENEGGER, Helga, 1090 Wien (AT); LISKA, Robert, 1200 Wien (AT); INFÜHR, Robert, 1090 Wien (AT)
(74) Vertreter: Ellmeyer, Wolfgang
(86) Internationale Anmeldenummer: PCT/AT2006/000271
(87) Internationale Veröffentlichungsnummer: WO 2007/002965

(56) Entgegenhaltungen:
- AT-B- 412 399
- US-A1- 2003 235 787

## Beschreibung

Die Erfindung betrifft ein formgebendes Verfahren, genauer gesagt ein Rapid-Prototyping-Verfahren unter Verwendung einer mit Strahlung zu einem festen Polymermaterial aushärtbaren Zusammensetzung.

### Stand der Technik

Mit sichtbarem bzw. UV-Licht härtbare Formulierungen sind aus vielen Bereichen der Technologie, wie der Beschichtungstechnik, Drucktechnik, Elektronik bekannt. Auch ist bekannt, derartige Zusammensetzungen in formgebenden Verfahren zu verwenden. So werden beim "Shape Deposition Manufacturing"-Verfahren (US-A-6.342.541) Gussformen für komplexe Formteile mit Hilfe von UV-härtbaren Formulierungen dadurch hergestellt, dass auf einer Basisplatte aus Wachs eine Schicht der flüssigen Formulierung mit Hilfe von UV-Licht ausgehärtet, diese Schicht dann spanabhebend bearbeitet und anschließend mit neuem Wachs umgeben wird. Dieser Vorgang wird so oft wiederholt, bis die gewünschte, mit der ausgehärteten Zusammensetzung als Stützmaterial gefüllte Wachsform erhalten wird. Das Stützmaterial wird anschließend mit wässriger Alkalilauge herausgelöst, wodurch die leere Wachsform für weitere Formgebungsprozesse verwendet werden kann.

Ähnliche Stützmaterialien werden in einem in der US-A-6.375.880 beschriebenen Formgebungsverfahren beschrieben, wobei das Stützmaterial entweder herausgelöst oder durch Aufschmelzen entfernt wird, wobei aber keinerlei Angaben über die chemische Zusammensetzung der Materialien enthalten sind.

Der Nachteil beider Formgebungsverfahren besteht vor allem in der notwendigen spanabhebenden mechanischen Bearbeitung jeder einzelnen Schicht nach der Aushärtung, was die Herstellung von komplexen Formteilen mit Hinterschneidungen sehr erschwert bzw. unmöglich macht. Weiters ist Prozessplanung durch die CNC-Fertigung ("Computer Numerical Control") sehr aufwändig.

Dies wird in der Stereolithographie durch selektives Aushärten vermieden (J.-C. André, A. Le Méhaute, and O. De Witt, FR-A-2.567.668 (1986), A. J. Herbert, J. Appl. Photo. Eng. 8(4), 185-188 (1982), C. Hull., US-A-4.575.330 (1986)). Dabei werden auf einer Bauplattform in einem Harzbad nacheinander dünne Harzschichten selektiv ausgehärtet (beispielsweise durch Abscannen mit einem UV-Laser oder selektive Belichtung) und so ohne mechanische Arbeitsschritte das Formteil erhalten. Die für diese Technik bisher verwendeten Harzformulierungen auf Basis von Acrylat- oder Epoxidharzen, wie sie etwa in WO 01/12679 beschrieben sind, ergeben vernetzte und daher unlösliche und unschmelzbare Bauteile, die selbst als Endprodukte verwendet werden, beispielsweise als Kunststoffeinlage in der Dentaltechnik.

Nachteilig ist dabei, dass die Eigenschaften des Bauteils durch die Zusammensetzung der verwendeten flüssigen Formulierung bestimmt sind, die aufgrund der Voraussetzung der Härtbarkeit durch Licht nur eingeschränkt variierbar ist. Will man Formteile aus anderen Materialien herstellen, dann sind weitere Arbeitsschritte erforderlich, bei denen das unlösliche und unschmelzbare Bauteil als Urform zur Herstellung von Gussformen dient. So wird z.B. bei der Silikonabformung die Urform in Silikon eingegossen und anschließend aus der so erhaltenen weichen Silikonform mechanisch entfernt. Abgesehen von dem zusätzlichen Arbeitsaufwand ist eine mechanische Entformung nur bei Teilen ohne oder mit geringen Hinterschneidungen möglich, so dass nach dieser Methode komplexe Bauteile nicht hergestellt werden können.

Eine andere Möglichkeit besteht im Einsatzgießen, wobei mit Hilfe der Urform eine Gussform aus anorganischem Material hergestellt wird und anschließend die Urform durch thermische Zersetzung entfernt wird. Dies erfordert nicht nur beträchtlichen Energieaufwand, sondern auch Gussformmaterialien, die Temperaturen bis etwa 600 °C standhalten können.

Als Alternative dazu wurden in AT-A-412.399 photopolymerisierbare wasserlösliche Zusammensetzungen beschrieben, die selektiv ausgehärtet werden können und wasserlösliche Polymere ergeben. Damit ist es möglich, ohne mechanische Behandlung der Gussformen komplexe Bauteile auch mit starken Hinterschneidungen herzustellen.

Diese wasserlöslichen Materialien haben aber nur einen begrenzten Einsatzbereich. So können keine wässrigen Verarbeitungshilfsmittel für den Abformprozess eingesetzt werden, da diese die Urform anquellen und anlösen. Außerdem kann es bereits durch Luftfeuchtigkeit zur Quellung des Materials kommen, was zu einer Verminderung der Maßhaltigkeit und damit zu einer Verschlechterung der exakten Formteilgeometrie führt.

Dies führt dazu, dass eine Reihe von wichtigen Materialien, die selbst aus wässrigen Formulierungen verarbeitet werden, bei diesem Prozess nicht eingesetzt werden können, wie z.B. aus dem Bereich der Sol-Gel-Chemie oder des Gelgießens. Speziell durch Gelgießen können wesentlich komplexere Geometrien hergestellt werden als mit traditionellen Methoden der keramischen Formgebung. Hierfür sind wasserlösliche Abformmaterialien ungeeignet, da diese keramischen Bauteile aus wasserbasierenden Gelen hergestellt werden (vgl. F. Costa et al., Journal of Non-Crystalline Solids 345-46, 787-789 (2004), V.K. Parashar et al., Microelectronic Engineering 67-8, 710-719 (2003), Y.F. Gu et al., Ceramics International 25 (8), 705-709 (1999)).

Auch das Abformen von Biomaterialien für medizinische Anwendungen, wie z.B. Hydrogel-Materialien mit komplexen Kanälen und Netzwerken, oder die Herstellung von Gerüststrukturen auf Basis von biokompatiblen und bioabbaubaren Verbundwerkstoffen (wie z.B. aliphatischen Polyestern auf Basis von Glykolsäuren bzw. Lactonen; vgl. S. Limpanuphap et al., Journal of Materials Science-Materials in Medicine 13(12),1163-1166 (2002)) ist mit solchen wasserlöslichen Zusammensetzungen nicht möglich.

Die Druckschrift US-A-2003235787 offenbart eine mit sichtbarem oder UV-Licht zu einem festen Polymermaterial aushärtbare Zusammensetzung umfassend Acrylsäureisobutylester und 1,3-Bis(3-Methacryloxypropyl)tetramethyldisiloxan (siehe die in den Absätzen [0036] und [0037] beschriebene Zusammensetzung 3).

Nachteilig bei den wasserlöslichen Zusammensetzungen ist auch die im Allgemeinen geringe Auflösungsgeschwindigkeit der Polymere in Wasser, wodurch sich oft Verzögerungen im Produktionsprozess von Formteilen ergeben.

Aufgabe der Erfindung ist somit die Behebung der oben erwähnten Nachteile durch Verbesserungen im Formgebungsverfahren und/oder in den darin verwendeten härtbaren Zusammensetzungen, wie z.B. strahlungshärtenden Formulierungen, die selektiv ausgehärtet werden können und aus denen mit oder ohne mechanische Behandlung mechanisch stabile Gussformen für komplexe Bauteile hergestellt werden können. Diese Gussformen sollen durch vorhandene Luftfeuchtigkeit nicht anquellen und damit verbesserte Abformgenauigkeiten sowie den Einsatz von Materialien, die aus wässrigen Systemen verarbeitet werden, ermöglichen. Weitere Aufgaben der Erfindung liegen in der Erzielung hoher Auflösungsgeschwindigkeit der Formen in geeigneten Lösungsmitteln bzw. raschem Schmelzen der Formen sowie verbesserten mechanischen Eigenschaften des Formmaterials, wodurch sich Vorteile bei der Produktion ergeben.

### Offenbarung der Erfindung

Die Erfinder haben im Zuge ihrer Forschungen herausgefunden, dass die obigen Aufgaben gelöst werden können, indem einerseits das im Rapid-Prototyping-Verfahren gebildete feste Polymermaterial vor oder gleichzeitig mit seiner Auflösung im Lösungsmittel und/oder seinem Aufschmelzen chemisch gespalten wird und andererseits die Gegenwart von Wasser im Verfahren weitestgehend vermieden wird.

Daher stellt die Erfindung in einem ersten Aspekt ein Verfahren gemäß Anspruch 1 zur Herstellung dreidimensionaler Objekte bereit, in dem eine dreidimensionale Struktur durch aufeinander folgende selektive Aushärtung von Schichten aus einer mit sichtbarem und/oder UV-Licht zu einem festen Polymermaterial aushärtbaren Zusammensetzung durch aufeinander folgende Bestrahlung der jeweiligen Schichten mit UV- und/oder sichtbarem Licht hergestellt wird, wonach unter Verwendung der so hergestellten dreidimensionalen Struktur ein dreidimensionales Objekt hergestellt wird, wonach die dreidimensionale Struktur aus bzw. von dem dreidimensionalen Objekt entfernt wird. Das Kennzeichen des erfindungsgemäßen Verfahrens besteht darin, dass das Entfernen der dreidimensionalen Struktur durch chemische Spaltung des Polymermaterials sowie gleichzeitiges oder darauf folgendes Auflösen des Materials in einem Lösungsmittel oder Lösungsmittelgemisch und/oder Aufschmelzen des Materials durchgeführt wird.

In Varianten dieses Verfahren kann die dreidimensionale Struktur einerseits als Urform zur Herstellung einer Gussform verwendet werden, wobei die dreidimensionale Struktur gemäß vorliegender Erfindung in ein Formmaterial eingebracht und/oder in sie ein Formmaterial eingebracht wird, nach dessen Verfestigung zur Gussform die Urform durch chemische Spaltung und Auflösen bzw. Aufschmelzen des Materials entfernt wird, wonach in der Gussform das dreidimensionale Objekt gegossen und verfestigt wird. Andererseits kann die dreidimensionale Struktur direkt als Gussform verwendet werden, in der das dreidimensionale Objekt gegossen und verfestigt wird, wonach die Gussform durch chemische Spaltung und Auflösen bzw. Aufschmelzen des Materials entfernt wird.

Auf diese Weise können in Rapid-Prototyping-Verfahren extrem hohe Auflösungs- bzw. Schmelzgeschwindigkeiten erzielt werden, da der Löse- bzw. Schmelzvorgang durch die vorhergehende oder gleichzeitige Spaltung des Polymermaterials unterstützt wird, so dass im Falle des Lösevorgangs der Angriff des Lösungsmittels erleichtert wird und weitaus effizientere, rückstandsfreiere und eben raschere Auflösung und Solvatation erfolgen kann. Andererseits kann - im Falle des Aufschmelzens - ein im ungespaltenen Zustand nicht oder erst bei (weitaus) höheren Temperaturen schmelzbares Polymermaterial nach erfolgter chemischer Spaltung rasch und unter geringerem Energieaufwand geschmolzen werden. In bevorzugten Ausführungsformen der Erfindung kann eine Kombination der beiden Vorgange, d.h. Lösen und Schmelzen, erfolgen, was besonders hohe Produktivität des Verfahrens ermöglicht. Im erfindungsgemäßen Verfahren können dadurch auch vernetzte, sogar stark vernetzte Polymermaterialien zum Einsatz kommen, was bislang auf dem Gebiet als unmöglich galt, solange sie spaltbare Vernetzungsstellen aufweisen. Durch Verwendung von derartigem vernetztem Material ist eine deutlich verbesserte Dimensionsgenauigkeit - sowohl der dreidimensionalen Strukturen als Formen als auch der damit gefertigten gewünschten dreidimensionalen Objekte - erzielbar.

Wenn zusätzlich oder als Alternative zum Aufschmelzen ein Auflöseschritt durchgeführt wird, kann das Lösungsmittel zwar auch weiterhin Wasser sein, erfindungsgemäß bevorzugt ist das Lösungsmittel jedoch zumindest ein organisches Lösungsmittel, noch bevorzugter ausgewählt aus der aus Tetrahydrofuran, Dioxan, Essigsäureethylester, Toluol und Gemischen zweier oder mehrerer dieser Lösungsmittel bestehenden Gruppe. Noch bevorzugter ist das Lösungsmittel im Wesentlichen wasserfrei.

Durch die weitestgehende Vermeidung von Wasser werden die eingangs beschriebenen Nachteile des Quellens und Anlösens der Formen mit wässrigen Systemen vermieden, so dass die Formen u.a. auch zur Herstellung von Objekten aus wässrigen Formulierungen, wie z.B. unter Anwendung von Sol-Gel-Verfahren oder Gelgießen, eingesetzt werden können.

Die chemische Spaltung des Kunststoffs kann mittels beliebiger Reagenzien erfolgen, die in der Lage sind, chemische Bindungen in festen Kunststoffen zu spalten, z.B. auch oxidativ unter Verwendung von Sauerstoff oder anderen, vorzugsweise starken, Oxidationsmitteln. Erfindungsgemäß bevorzugt erfolgt die Spaltung jedoch unter Verwendung zumindest einer Säure oder Base, da auf diese Weise hohe Reaktionsgeschwindigkeiten der Spaltprozesse erzielbar sind. Die dazu eingesetzten Säuren oder Basen sind vorzugsweise organische Säuren und Basen, um gute Löslichkeit in organischen Lösungsmitteln zu gewährleisten und den Einsatz von Wasser weitestgehend vermeiden zu können. Noch bevorzugter werden die Basen aus der aus Butylamin, Hexylamin, Octylamin und Gemischen zweier oder mehrerer dieser Basen bestehenden Gruppe ausgewählt. Die Säuren werden noch bevorzugter aus der aus Ameisensäure, Essigsäure, Methansulfonsäure und Gemischen zweier oder mehrerer dieser Säuren bestehenden Gruppe ausgewählt.

Ein zweiter Aspekt der vorliegenden Erfindung betrifft die Verwendung gemäß Anspruch 9 einer mit sichtbarem und/oder UV-Licht zu einem spaltbare Bindungen enthaltenden, festen Polymermaterial aushärtbaren Zusammensetzung, die Folgendes umfasst:
a) 20 bis 90 Gew. % zumindest einer Verbindung der allgemeinen Formel

   **CH₂=C(R')-X**

   worin
   R' für Wasserstoff oder eine CH₃-Gruppe steht,
   X für -CO-OR¹, -CONR¹R², -O-CO-R¹, -OR¹, -C₆H₅ oder -Z-R-Y steht,
      worin R¹ und R² unabhängig voneinander für einen verzweigten Alkyl-Rest mit 3 bis 20 C-Atomen, einen gegebenenfalls mit einer oder mehreren linearen oder verzweigten Alkylgruppen substituierten 6- bis 10-gliedrigen cycloaliphatischen Rest, der ein oder mehrere Heteroatome, vorzugsweise ein, zwei oder drei Heteroatome, als Ringglieder aufweisen kann, einen mit zumindest einer linearen oder verzweigten Alkylengruppe überbrückten cycloaliphatischen Rest mit 6 bis 20 C-Atomen oder einen aromatischen Rest mit 6 bis 30 C-Atomen stehen,
   Z für -CO-O- oder -CO-NH- steht,
   R für einen linearen oder verzweigten Alkylen-Rest mit 1 bis 20 C-Atomen, einen cycloaliphatischen Rest mit 6 bis 10 C-Atomen oder einen aromatischen Rest mit 6 bis 30 C-Atomen steht und
   Y für -NR¹R², -O-CO-NR¹R², -NH-CO-OR¹, -NH-CO-R¹, -O-CO-R¹, -CO-OR¹, -CO-NHR¹ oder -OR¹ steht;
b) 5 bis 50 Gew.-% zumindest eines spaltbaren Vernetzers;
c) 0,01 bis 5 Gew.-% zumindest eines Initiators;
d) 0 bis 5 Gew.-% zumindest eines Coinitiators; und
e) 0 bis 70 Gew.-% eines oder mehrerer Zusatzstoffe, ausgewählt aus der aus Füllstoffen, Stabilisatoren, Viskositätsmodifikatoren und Lösungsmitteln bestehenden Gruppe.

Derartige strahlungshärtende Zusammensetzungen und Formulierungen enthalten als wesentliche Komponente zumindest einen spaltbaren, vorzugsweise mit Säure oder Base hydrolysierbaren Vernetzer. Nach der Aushärtung ergibt eine solche erfindungsgemäße Formulierung einen mechanisch stabilen, in wässrigen Medien unlöslichen und nicht quellbaren Formteil, der als Urform zur Herstellung einer Gussform oder direkt als Gussform eingesetzt werden kann. Diese wird anschließend wie oben beschrieben durch Auflösen in einem organischen Lösungsmittel, das vorzugsweise organische, saure bzw. basische Komponenten enthält, und/oder durch Aufschmelzen aus der Form bzw. vom darin gefertigten dreidimensionalen Objekt entfernt. Trotz der vernetzten Struktur sind bei Verwendung von speziellen Lösungsmittelgemischen erheblich höhere Auflösungsgeschwindigkeiten als bei nicht vernetzten oder bei wasserlöslichen Gussformen zu beobachten, selbst ohne gleichzeitig durchgeführten Schmelzvorgang.

In bevorzugten Ausführungsform steht in Bestandteil a) X für -CO-OR¹ oder -CONR¹R², worin R¹ und R² unabhängig voneinander einen verzweigten Alkyl-Rest mit 3 bis 10 C-Atomen, einen 6- bis 10-gliedrigen cycloaliphatischen Rest, der ein oder mehrere Heteroatome, vorzugsweise ein oder zwei Heteroatome, als Ringglieder aufweisen kann, einen mit zumindest einer linearen oder verzweigten Alkylengruppe überbrückten cycloaliphatischen Rest mit 6 bis 16 C-Atomen oder -C₆H₅ darstellen. Besonders bevorzugt ist Bestandteil a) aus der aus Methacrylsäureisobutylester, Acrylsäure-2-ethylhexylester, Acrylsäurecyclohexylester, Acrylsäureisobornylester, Diisobutylacrylamid, Cyclohexylacrylamid, Isobornylacrylamid, N-Acrylpiperidin und N-Methyl-N-cyclohexylacrylamid bestehenden Gruppe ausgewählt. Unter Verwendung derartiger Verbindungen als Bestandteil a) sind besonders gute Ergebnisse erzielbar. So können beispielsweise unter Einsatz verzweigter Monomere deutlich bessere mechanische Eigenschaften des gehärteten Polymermaterials erzielt werden, was Vorteile im Abformprozess bietet. Beispielsweise weisen Dibutylacrylamid-Homopolymere eine Shore-Härte von etwa 23 auf, während Diisobutylacrylamid Homopolymere mit einer Shore-Härte von 73 liefert.

Der zumindest eine spalt- bzw. hydrolysierbare Vernetzer ist daher vorzugsweise aus Methacrylsäureanhydrid, Bis(methacryloyloxy)dimethylsilan, Bis(methacryloyloxy)-tetramethyldisiloxan und Dimethylsilylen-bis(oxyethylenmethacrylat) ausgewählt.

Die Zusammensetzung ist vorzugsweise zu einem auch ohne vorhergehende chemische Spaltung in organischen Lösungsmitteln löslichen, festen Polymermaterial aushärtbar, um besonders hohe Auflösungsraten zu erzielen und um Polymere aus den unter a) angeführten Monomeren, d.h. ohne den spaltbaren Vernetzer, als Füllstoffe zu den vernetzten Polymeren zusetzen zu können, wie dies nachstehend detaillierter beschrieben wird. Sie ist insbesondere zu einem säure- oder basenspaltbaren Polymermaterial aushärtbar, um auch in bevorzugten Ausführungsformen des Verfahrens gemäß dem ersten Aspekt der Erfindung zur Herstellung von dreidimensionalen Strukturen und Objekten eingesetzt zu werden.

Die Zusammensetzung ist weiters vorzugsweise zu einem Polymermaterial aushärtbar, das, gegebenenfalls nach erfolgter chemischer Spaltung zumindest einer Bindung des zumindest einen spaltbaren Vernetzers, schmelzbar ist, um es - alternativ oder zusätzlich zur Auflösung in organischem Lösungsmittel - durch einen Schmelzvorgang entfernen zu können, was, wie bereits erwähnt, besonders rasche Entfernung des Materials in einem Verfahren gemäß dem ersten Aspekt der vorliegenden Erfindung ermöglicht.

### Detallierte Beschreibung der Erfindung

Die unter a) angeführten Verbindungen härten bei Bestrahlung mit UV- oder sichtbarem Licht aus. Dabei können erfindungsgemäß entweder reine Monomere oder auch Gemische eingesetzt werden. Weiters sind auch Makromonomere geeignet, die aus den genannten Verbindungen nach bekannten Methoden hergestellt werden können. Ein bevorzugtes Merkmal der Erfindung ist die Löslichkeit des aus diesen Monomeren erzeugten Polymermaterials in organischen Lösungsmitteln, insbesondere in wasserfreien Lösungsmitteln. Die Offenbarung der AT-A-412.399 umfasst zwar mehrere ähnliche Monomere, z.B. ähnlich substituierte (Meth)acrylamide, diese müssen aber nach dortiger Lehre zwingend wasserlösliche Polymere ergeben, was gemäß vorliegender Erfindung nicht nur nicht bevorzugt, sondern vorzugsweise sogar zu vermeiden ist, um die mit Quellung einhergehenden Probleme zu beseitigen.

Es existieren zwar Überschneidungen bei den Definitionen von R¹ und R² zwischen der AT-A-412.399 und der vorliegenden Erfindung, allerdings sind diese rein formaler Natur. Gemäß AT-A-412.399 sind R¹ und R² jeweils Wasserstoff oder "Alkylgruppen mit 1 bis 6 Kohlenstoffatomen", während sie hierin für "verzweigte Alkylreste mit 3 bis 20 Kohlenstoffatomen" bzw. für "6- bis 10-gliedrige cycloaliphatische Reste" stehen. Ein durchschnittlicher Fachmann, der nach Lektüre der AT-A-412.399 vor der Aufgabe steht, ein wasserlösliches Polymer aus den dort offenbarten Zusammensetzungen zu synthetisieren, wird aus der Option "Alkylgruppen mit 1 bis 6 Kohlenstoffatomen" kaum verzweigte, längerkettige Vertreter dieser Gruppe oder Cyclohexylreste, sondern vielmehr lineare, kurzkettige Alkylreste wählen, um die Wasserlöslichkeit zu optimieren. Mitunter wird er die Option sogar unwillkürlich als "lineare Alkylgruppen mit 1 bis 6 Kohlenstoffatomen" interpretieren.

Im Gegensatz dazu sind die Alkylgruppen für R¹ und R² hierin so zu wählen, dass ein in organischen Lösungsmitteln lösliches Polymer erhalten wird, das zudem verbesserte mechanische Eigenschaften aufweisen soll, weswegen erfindungsgemäß verzweigte Reste mit 3 bis 20 Kohlenstoffatomen oder cycloaliphatische Reste mit 6 bis 10 Ringgliedern zum Einsatz kommen. Wie zuvor erwähnt bewirken verzweigte Alkylketten beispielsweise eine deutlich höhere Shore-Härte der Polymere als unverzweigte Reste gleicher Kettenlänge. Ähnliches gilt analog für zyklische Reste, die als ringgeschlossene verzweigte Rest ansehbar sind. Somit stellen die Überschneidungen "verzweigte Alkylreste mit 3 bis 6 Kohlenstoffatomen" und "6-gliedrige cycloaliphatische Reste" eine spezielle Auswahl aus dem nach dem Stand der Technik bekannten Bereich dar, die den Zusammensetzungen der vorliegenden Erfindung neue, von den Erfindern der AT-A-412.399 nicht erkannte und dort sogar unerwünschte Wirkungen verleiht.

Die unter b) bezeichneten Vernetzer sind gemäß vorliegender Erfindung di- oder mehrfunktionelle polymerisierbare Verbindungen, in welchen die polymerisierbaren Reste über leicht spalt- bzw. hydrolysierbare Gruppen, wie z.B. Anhydrid-, Ester-oder Silyl-Gruppen gebunden sind. Im Gegensatz zur AT-A-412.399 sind die hydrolysierbaren Vernetzer ein wesentliches Merkmal der erfindungsgemäßen Zusammensetzung, da sich durch die Vernetzung bei der Polymerisation mechanisch stabile Formen mit hoher Maßhaltigkeit ergeben, die bei Verwendung wässriger Formulierungen zum Gießen des gewünschten dreidimensionalen Objekts in Wasser nicht quellen.

Auch die AT-A-412.399 erwähnt ein hierin als erfindungsgemäßer spaltbarer Vernetzer offenbartes Monomer, nämlich Methacrylsäureanhydrid. Dieses stellt dort allerdings das einzige difunktionelle Monomer dar. Zudem war den Erfindern der AT-A-412.399 der Mechanismus der vorliegenden Erfindung, der auf chemischer Spaltung des spaltbaren Vernetzers und gleichzeitigem oder darauf folgendem Lösen bzw. Schmelzen des Polymermaterials beruht, nicht bekannt. Vielmehr waren vernetzte Polymere aufgrund der im Allgemeinen geringen Auflösungsgeschwindigkeit sogar unerwünscht, so dass das dort als (Co-)Monomer erwähnte Methacrylsäureanhydrid als zufällige Vorwegnahme bzw. seine Verwendung in den Zusammensetzungen der vorliegenden Erfindung erneut als Auswahlerfindung anzusehen ist.

Die unter c) angeführten Initiatoren sind aus der Technologie der Strahlungshärtung bekannte Photoinitiatoren, wie z.B. Benzophenone, Thioxanthone, Benzoine, Benzilketale, Hydroxyalkylphenone, Aminoalkylphenone, Acylphosphinoxide, Titanocene, Ferrocene, Farbstoff/Coinitiator-Systeme, 1,2-Diketone wie Campherchinon oder Benzil, Ketocumarine oder Phenylglyoxylate.

Im Falle von Typ-II-Photoinitiatoren enthält die Zusammensetzung noch einen unter d) angeführten Anteil (> 0 Gew.-%) an Coinitiator, wofür z.B. tertiäre aliphatische und oder aromatische Amine, Arylsulfinate, Enolate, Thioharnstoffe oder Barbitursäurederivate in Frage kommen.

Die unter e) angeführten Zusatzstoffe sind z.B. Füllstoffe, die zur Einstellung der Viskosität der flüssigen Ausgangsmischung bzw. auch zur Verbesserung der mechanischen Stabilität und/oder der Schmelzbarkeit der ausgehärteten Polymermaterialien dienen. Hierfür sind in organischen Lösungsmitteln lösliche Oligo- bzw. Polymere wie z.B. Polypropylenoxid, Polyvinylacetat oder Polymere aus den unter a) angeführten Monomeren geeignet. Auch Derivate auf Basis von Cellulose, wie z.B.: Celluloseacetat oder Celluloseacetobutyrat können dafür eingesetzt werden.

Auch anorganische Füllstoffe können in der strahlungshärtenden Zusammensetzung dispergiert sein, wie z.B. Siliziumdioxid, amorphe Kieselsäure, Aluminiumoxid, Keramik oder Quarz, wobei die Korngröße zwischen 0,01 und 100 µm variieren kann.

Schließlich kann die Zusammensetzung auch noch Zusatzstoffe wie Lösungsmittel, Polymerisationsinhibitoren, Sensibilisatoren, Dispergiermittel etc. enthalten.

Generell gilt, dass sämtliche Komponenten a) bis e) so aufeinander abgestimmt sein müssen, dass die Wirkung der Erfindung, vor allem die hohe Auflösungsgeschwindigkeit des daraus erzeugten festen Polymermaterials in organischen Lösungsmitteln bzw. gute Schmelzbarkeit, gegebenenfalls nach chemischer Spaltung, nicht beeinträchtigt wird. Allerdings kann in speziellen Fällen, in denen keine allzu rasche Auflösung gewünscht wird, die Auflösungsgeschwindigkeit und/oder die Schmelzbarkeit eines relativ schwach vernetzten Polymers durch die Wahl geeigneter Zusatzstoffe bewusst gesenkt werden. Der durchschnittliche Fachmann ist in der Lage, das System den jeweiligen Gegebenheiten entsprechend abzustimmen und anzupassen.

Allgemein sind gemäß vorliegender Erfindung folgende Bestandteile bevorzugt:
- Monomere, wie z.B. Methacrylsäureisobutylester, Acrylsäure-2-ethyl-hexylester, Acrylsäurecyclohexylester, Acrylsäureisobornylester, Diisobutyl-acrylamid, Diisopropylmethacrylamid, N-Methyl-N-cyclohexylacrylamid, N-(1,1,3,5-Tetramethyl)-octylacrylamid, Cyclohexylacrylamid, Isobornylacrylamid, N-Acrylpiperidin;
- spaltbare Vernetzer, wie z.B. Methacrylsäureanhydrid, 2-Methacryloyloxydodecansäureanhydrid, 16-Methacryloyloxyhexadecansäureanhydrid, Silyl(meth)-acrylate wie Bis(methacryloyloxy)dimethylsilan, Bis(methacryloyloxy)tetramethyldisiloxan (vgl. EP 624.827 A1), Dimethylsilylen-bis(oxyethylenacrylat), Dimethylsilylen-bis(oxyethylenmethacrylat) oder Tetra(methacryloyloxy)silan, Borsäureester wie Allylborat, Tris(2-methacryloyloxyethyl)borat, Tris(2-methacryloyl)borat, Tris-(N-(2-hydroxyethyl)acrylamid)borat (vgl. US-A-3.743.686), sowie oxidativ spaltbare Verbindungen wie N,N'-Bis(acryloyl)cystamin, 2-Buten-1,4-di(meth)acrylat; sowie Sorbit-di(meth)acrylat.
- Photoinitiatoren wie Campherchinone, Acylphosphinoxide und Titanocene;
- Coinitiatoren auf Basis tertiärer Amine, wie z.B. Dimethylaminobenzoesäureethylester, Dimethylanilin, Triethanolamin, Methyldiethanolamin;
- Füllstoffe, wie z.B. Celluloseacetobutyrat, Polymethylmethacrylat oder Polystyrol;
- Zuatzstoffe, wie z.B. Hydrochinonmonomethylether und Sensibilisatoren auf Anthrachinonbasis.

Erfindungsgemäß besonders bevorzugt sind Zusammensetzungen bestehend aus:
40-90% eines Gemischs der Monomere Diisobutylacrylamid, Acrylsäureisobornylester, Acrylsäurecyclohexylester, N-Methyl-N-cyclohexylacrylamid, lsobornylacrylamid;
5-25 % Methacrylsäureanhydrid oder Dimethylsilylen-bis(oxyethylenacrylat) als Vernetzer;
1-5% Photoinitiator Irgacure 819; und
0-40% Celluloseacetobutyrat als Füllstoff.

Die vorgeschriebenen Mengen an Monomeren, Initiatoren, Coinitiatoren und sonstigen Zusatzstoffe werden vermischt und das flüssige Gemisch als Bad in einer für Rapid-Prototyping verwendeten Anordnung zur Herstellung von dreidimensionalen Objekten eingesetzt, wie z.B. in der in der WO 01/12679 beschriebenen Vorrichtung. Dabei wird auf einer unterhalb der Badoberfläche befindlichen horizontal ausgerichteten Bauplattform durch selektive Belichtung ein 2D-Schnitt des gewünschten Bauteils hergestellt. Je nach Zusammensetzung der photohärtenden Mischung und Belichtungszeit werden Aushärtetiefen von 1 bis 100 µm erreicht. Durch Absenken der Bauplattform wird auf dem ausgehärteten ersten 2D-Schnitt die nächste Schicht durch erneute selektive Belichtung hergestellt. Auf diese Weise wird durch stufenweises Absenken der Plattform und erneute Photohärtung das fertige Objekt erhalten.

Dieses kann nun als Urform zur Herstellung einer Form verwendet werden, indem es beispielsweise in Wachs oder eine Silikonabformmasse eingegossen wird. Nach der Verfestigung des Wachses wird das im Inneren befindliche Material herausgelöst, wobei erfindungsgemäß organische Lösungsmittel, wie z.B. THF, Dioxan, Essigsäureethylester oder Toluol, in Kombination mit organischen Basen wie N-Butylamin, Hexylamin oder Octylamin eingesetzt werden können, von denen das Wachs nicht angegriffen wird. Alternativ oder zusätzlich dazu kann das Material auch herausgeschmolzen werden, wenn es einen niedrigeren Schmelzpunkt als die Silikonmasse aufweist.

Die so erhaltene leere Form kann nun zur Herstellung von Objekten aus beliebigen organischen oder anorganischen Materialien oder Composit-Materialien eingesetzt werden, beispielsweise aus thermoplastischen oder duroplastischen, d.h. vernetzten, Polymeren, keramische Bauteile durch Gelgießen von Keramik (vgl. J. Stampfl et al., Materials Science and Engineering A 334(1-2), 187-192 (2002), A.C. Young et al., J. Am. Ceram. Soc. 74(3), 612-618 (1991)) usw.

Alternativ kann die erfindungsgemäße Zusammensetzung aber auch direkt zur Herstellung von Gussformen verwendet werden. Dabei wird die selektive Belichtung der Schichten so gesteuert, dass ein Hohlkörper aus dem ausgehärteten Material entsteht, der nun als Gussform verwendet wird. Diese Form wird mit einer flüssigen Harzmischung - z.B. Epoxidharz, ungesättigtes Polyesterharz, Acrylatharz - gefüllt, die in der Form ausgehärtet wird. Anschließend wird die umgebende Form aufgelöst und/oder weggeschmolzen, wobei im Falle des Lösens gängige organische Lösungsmittel in Kombination mit organischen Basen eingesetzt werden, von denen der in der Gussform befindliche Bauteil nicht angegriffen wird. Die Verwendung der erfindungsgemäßen Zusammensetzung zur Herstellung von Gussformen ist insbesondere dann vorteilhaft, wenn der damit hergestellte Bauteil ohne chemische Spaltung unlöslich und/oder unschmelzbar ist, also z.B. bei der Herstellung von Bauteilen aus vernetzten Polymeren.

In speziellen Ausführungsformen kann sowohl zur Herstellung einer löslichen Urform als auch zur Herstellung der damit hergestellten Form eine erfindungsgemäße Zusammensetzung eingesetzt werden, so dass der erfindungsgemäße Spalt- und Auflösungs- bzw. Schmelzprozess in einem Herstellungsverfahren für ein dreidimensionales Objekt zweimal zur Anwendung kommen kann. Dies kann beispielsweise dadurch realisiert werden, dass das Polymermaterial für die Urform mit Säuren, jenes für die daraus hergestellte eigentliche Form jedoch mit Base spaltbar ist oder umgekehrt und/oder dass die beiden Polymermaterialien in unterschiedlichen organischen Lösungsmitteln löslich sind und/oder dass eines der Materialien bei deutlich niedrigerer Temperatur schmelzbar ist als das andere.

Ein besonders Vorteil der erfindungsgemäßen Zusammensetzung besteht darin, dass die meisten Polymere sich in organischen Lösungsmitteln wesentlich schneller lösen als in Wasser. Überraschenderweise konnte festgestellt werden, dass der Einsatz von spalt- bzw. hydrolysierbaren Vernetzern nicht nur die Bauteilmaßhaltigkeit verbessert, sondern auch den Auflöseprozess deutlich beschleunigt. Hierfür ist es häufig notwendig, zu den gängigen organischen Lösemitteln Basen wie Butylamin, Hexylamin oder Octylamin oder organische Säuren wie Ameisensäure, Essigsäure oder Methansulfonsäure zuzusetzen. Damit ergibt sich bei der Herstellung von Formteilen ein wesentlicher Vorteil gegenüber den in AT-A-412-399 offenbarten wasserlöslichen Zusammensetzungen.

In den folgenden Beispielen sind erfindungsgemäße Zusammensetzungen angeführt, die in Rapid-Prototyping-Verfahren als Urformen bzw. Formmaterialien für die Herstellung von Gussformen eingesetzt werden können. Weiters sind als Vergleichsbeispiele mehrere, zum Teil aus der AT-A-412.399 bekannte, wasserlösliche Formulierungen angeführt, deren Löslichkeit und Wasseraufnahme mit den erfindungsgemäßen Formulierungen verglichen werden (siehe Tabelle 1). Für die Bestimmung der Löslichkeit wird ein (10 x 5 x 4 mm) großer Probekörper im entsprechenden Lösungsmittel bei Raumtemperatur gerührt. Die Quantifizierung erfolgt über die Angabe der für die vollständige Auflösung benötigten Zeit (auf volle 5 min gerundet).

### Beispiele

| **Beispiel 1** | | **Gew %** |
|---|---|---|
| Monomer | Diisobutylacrylamid | 87 |
| Vernetzer | Methacrylsäureanhydrid | 10 |
| Photoinitiator | Irgacure 819 | 3 |
| **Beispiel 2** | | **Gew %** |
| Monomer | Diisobutylacrylamid | 87 |
| Vernetzer | Bis(methacryloyloxy)dimethylsilan | 10 |
| Photoinitiator | Irgacure 819 | 3 |
| **Beispiel 3** | | **Gew %** |
| Monomer | Diisobutylacrylamid | 86 |
| Vernetzer | Methacrylsäureanhydrid | 10 |
| Photoinitiator | Campherchinon | 2 |
| Coinitiator | Dimethylaminobenzoesäureethylester | 2 |
| **Beispiel 4** | | **Gew %** |
| Monomer | Diisobutylacrylamid | 86 |
| Vernetzer | Bis(methacryloyloxy)dimethylsilan | 10 |
| Photoinitiator | Campherchinon | 2 |
| Coinitiator | Dimethylaminobenzoesäureethylester | 2 |

| **Beispiel 5** | | **Gew %** |
|---|---|---|
| Monomer | Diisobutylacrylamid | 71 |
| Vernetzer | Methacrylsäureanhydrid | 20 |
| Photoinitiator | Irgacure 819 | 3 |
| Füllstoff | Celluloseacetatbutyrat | 6 |
| **Beispiel 6** | | **Gew %** |
| Monomer | Diisobutylacrylamid | 71 |
| Vernetzer | Bis(methacryloyloxy)dimethylsilan | 20 |
| Photoinitiator | Irgacure 819 | 3 |
| Füllstoff | Celluloseacetatbutyrat | 6 |
| **Beispiel 7** | | **Gew %** |
| Monomere | Acrylsäureisobornylester | 80 |
| Vernetzer | Methacrylsäureanhydrid | 17 |
| Photoinitiator | Irgacure 819 | 3 |
| **Beispiel 8** | | **Gew %** |
| Monomere | Acrylsäureisobornylester | 80 |
| Vernetzer | Bis(methacryloyloxy)dimethylsilan | 17 |
| Photoinitiator | Irgacure 819 | 3 |
| **Beispiel 9** | | **Gew %** |
| Monomere | Acrylsäurecyclohexylester | 60 |
| | Diisobutylacrylamid | 12 |
| Vernetzer | Methacrylsäureanhydrid | 10 |
| Photoinitiator | Irgacure 819 | 3 |
| Füllstoff | Celluloseacetatbutyrat | 15 |

| **Beispiel 10** | | **Gew %** |
|---|---|---|
| Monomere | Acrylsäurecyclohexylester | 60 |
| | Diisobutylacrylamid | 12 |
| Vernetzer | Bis(methacryloyloxy)dimethylsilan | 10 |
| Photoinitiator | Irgacure 819 | 3 |
| Füllstoff | Celluloseacetatbutyrat | 15 |
| **Vergleichsbeispiel 1** | **(V1)** | **Gew %** |
| Monomer | Acrylsäure | 97 |
| Photoinitiator | Irgacure 819 | 3 |
| **Vergleichsbeispiel 2** | **(V2)** | **Gew %** |
| Monomere | Acrylsäure | 80 |
| | Acrylsäure-2-dimethylaminoethylester | 17 |
| Photoinitiator | lrgacure 819 | 3 |
| **Vergleichsbeispiel 3** | **(V3)** | **Gew %** |
| Monomere | Acrylsäure | 60 |
| | Acrylsäure-2-dimethylaminoethylester | 17 |
| Photoinitiator | Irgacure 819 | 3 |
| Füllstoff | Polyvinylalkohol | 20 |
| **Vergleichsbeispiel 4** | **(V4)** | **Gew %** |
| Monomere | Diisobutylacrylamid | 80 |
| | Acrylsäureisobornylester | 17 |
| Photoinitiator | Irgacure 819 | 3 |

**Tabelle 1**

| Beispiel | Gewichtszunahme bei Lagerung bei Normklima, 24h | Löslichkeit |
|---|---|---|
| V1 | 4% | 360 min ¹⁾ |
| V2 | 5% | 270 min ¹⁾ |
| V3 | 10% | 240 min ¹⁾ |
| V4 | 0,3% | 85 min ²⁾ |
| | | |
| 1 | 0,1% | 30 min ³⁾ |
| 2 | < 0,1% | 25 min ³⁾ |
| 3 | 0,1% | 30 min ³⁾ |
| 4 | < 0,1% | 25 min ³⁾ |
| 5 | 0,1% | 25 min ³⁾ |
| 6 | < 0,1% | 20 min ³⁾ |
| 7 | 0,1% | 30 min ³⁾ |
| 8 | < 0,1% | 25 min ³⁾ |
| 9 | 0,2% | 40 min ²⁾ |
| 10 | 0,1% | 30 min ²⁾ |

| | | |
|---|---|---|
| ¹⁾ in 1 N NaOH ²⁾ in THF ³⁾ in THF/Butylamin (1:1) | | |

Wie aus Tabelle 1 klar hervorgeht, quellen die aus erfindungsgemäßen Zusammensetzungen hergestellten Probekörper in weitaus geringerem Maße (im Mittel um etwa den Faktor 40) mit Luftfeuchtigkeit und lösen sich in organischem Lösungsmittel um etwa den Faktor 10 rascher auf als jene, die aus Zusammensetzungen nach dem Stand der Technik hergestellt wurden. Durch Zusatz von organischer Base kann die Auflösungsgeschwindigkeit um etwa 25-30% beschleunigt werden.

Ein Vergleich zwischen Vergleichsbeispiel 4 und den Ausführungsbeispielen der Erfindung, vor allem den Beispielen 1, 2, 7 und 8, in denen dieselben Monomere wie in V4, allerdings unter Zusatz des erfindungsgemäßen Vernetzers eingesetzt werden, zeigt, dass in V4 zwar ein Wasseraufnahmevermögen innerhalb derselben Größenordnung erzielt wird, dass aber die Auflösung immer noch mehr als dreimal so lange dauert wie bei Ausführungsformen der vorliegenden Erfindung.

Weiters ist aus dem Vergleich der Beispielpaare 1/2, 3/4, 5/6, 7/8 und 9/10, die sich nur durch den jeweils eingesetzten Vernetzer unterscheiden, erkennbar, dass durch Verwendung von - gegenüber Methacrylsäureanhydrid - hydrophoberem Bis(methacryloyloxy)dimethylsilan als Vernetzer eine noch geringere Wasseraufnahme ermöglicht wird. Zudem beschleunigt die leichtere Spaltbarkeit der Silanolesterbindung die Auflösung um weitere 20-25%.

## Patentansprüche

1. Verfahren zur Herstellung dreidimensionaler Objekte, umfassend die Herstellung einer dreidimensionalen Struktur durch aufeinander folgende selektive Aushärtung von Schichten aus einer mit sichtbarem und/oder UV-Licht zu einem festen Polymermaterial aushärtbaren Zusammensetzung durch aufeinander folgende Bestrahlung der jeweiligen Schichten mit UV- und/oder sichtbarem Licht, wonach unter Verwendung der so hergestellten dreidimensionalen Struktur ein dreidimensionales Objekt hergestellt wird, wonach die dreidimensionale Struktur aus bzw. von dem dreidimensionalen Objekt entfernt wird, wobei
das Entfernen der dreidimensionalen Struktur durch chemische Spaltung des Polymermaterials sowie gleichzeitiges oder darauf folgendes Auflösen des Materials in einem Lösungsmittel oder Lösungsmittelgemisch und/oder Aufschmelzen des Materials durchgeführt wird.

2. Verfahren nach Anspruch 1, **dadurch gekennzeichnet, dass** die dreidimensionale Struktur als Urform zur Herstellung einer Gussform verwendet wird, indem die dreidimensionale Struktur in ein Formmaterial eingebracht und/oder in sie ein Formmaterial eingebracht wird, nach dessen Verfestigung zur Gussform die Urform durch chemische Spaltung sowie Auflösen und/oder Aufschmelzen des Materials entfernt wird, wonach in der Gussform das dreidimensionale Objekt gegossen und verfestigt wird.

3. Verfahren nach Anspruch 1, **dadurch gekennzeichnet, dass** die dreidimensionale Struktur als Gussform verwendet wird, in der das dreidimensionale Objekt gegossen und verfestigt wird, wonach die Gussform durch chemische Spaltung sowie Auflösen und/oder Aufschmelzen des Materials entfernt wird.

4. Verfahren nach einem der Ansprüche 1 bis 3, **dadurch gekennzeichnet, dass** das Material gelöst wird und das Lösungsmittel aus der aus Tetrahydrofuran, Dioxan, Essigsäureethylester, Toluol und Gemischen zweier oder mehrerer dieser Lösungsmittel bestehenden Gruppe ausgewählt wird.

5. Verfahren nach einem der vorangegangenen Ansprüche, **dadurch gekennzeichnet, dass** ein im Wesentlichen wasserfreies Lösungsmittel eingesetzt wird.

6. Verfahren nach einem der vorangegangenen Ansprüche, **dadurch gekennzeichnet, dass** die chemische Spaltung des Kunststoffs unter Verwendung zumindest einer Säure oder Base durchgeführt wird.

7. Verfahren nach Anspruch 6, **dadurch gekennzeichnet, dass** die Base aus der aus Butylamin, Hexylamin, Octylamin und Gemischen zweier oder mehrerer dieser Basen bestehenden Gruppe ausgewählt wird.

8. Verfahren nach Anspruch 6, **dadurch gekennzeichnet, dass** die Säure aus der aus Ameisensäure, Essigsäure, Methansulfonsäure und Gemischen zweier oder mehrerer dieser Säuren bestehenden Gruppe ausgewählt wird.

9. Verwendung einer mit sichtbarem und/oder UV-Licht zu einem festen Polymermaterial aushärtbaren Zusammensetzung in einem Verfahren zur Herstellung dreidimensionaler Objekte nach einem der Ansprüche 1 bis 8, wobei die Zusammensetzung Folgendes umfasst:
a) 20 bis 90 Gew. % zumindest einer Verbindung der allgemeinen Formel
**CH₂=C(R')-X**
worin
R' für Wasserstoff oder eine CH₃-Gruppe steht,
X für -CO-OR¹, -CONR¹R², -O-CO-R¹, -OR¹, -C₆H₅ oder -Z-R-Y steht,
worin R¹ und R² unabhängig voneinander für einen verzweigten Alkyl-Rest mit 3 bis 20 C-Atomen, einen gegebenenfalls mit einer oder mehreren linearen oder verzweigten Alkylgruppen substituierten 6- bis 10-gliedrigen cycloaliphatischen Rest, der ein oder mehrere Heteroatome, vorzugsweise ein, zwei oder drei Heteroatome, als Ringglieder aufweisen kann, einen mit zumindest einer linearen oder verzweigten Alkylengruppe überbrückten cycloaliphatischen Rest mit 6 bis 20 C-Atomen oder einen aromatischen Rest mit 6 bis 30 C-Atomen stehen,
Z für -CO-O- oder -CO-NH- steht,
R für einen linearen oder verzweigten Alkylen-Rest mit 1 bis 20 C-Atomen, einen cycloaliphatischen Rest mit 6 bis 10 C-Atomen oder einen aromatischen Rest mit 6 bis 30 C-Atomen steht und
Y für -NR¹R², -O-CO-NR¹R², -NH-CO-OR¹, -NH-CO-R¹, -O-CO-R¹, -CO-OR¹, -CO-NHR¹ oder -OR¹ steht;
b) 5 bis 50 Gew.-% zumindest eines spaltbaren Vernetzers;
c) 0,01 bis 5 Gew.-% zumindest eines Initiators;
d) 0 bis 5 Gew.-% zumindest eines Coinitiators; und
e) 0 bis 70 Gew.-% eines oder mehrerer Zusatzstoffe, ausgewählt aus der aus Füllstoffen, Stabilisatoren, Viskositätsmodifikatoren und Lösungsmitteln bestehenden Gruppe.

10. Verwendung nach Anspruch 9, **dadurch gekennzeichnet, dass** in Bestandteil a) X für -CO-OR¹ oder -CONR¹R² steht, worin R¹ und R² unabhängig voneinander einen verzweigten Alkyl-Rest mit 3 bis 10 C-Atomen, einen 6- bis 10-gliedrigen cycloaliphatischen Rest, der ein oder mehrere Heteroatome, vorzugsweise ein oder zwei Heteroatome, als Ringglieder aufweisen kann, einen mit zumindest einer linearen oder verzweigten Alkylengruppe überbrückten cycloaliphatischen Rest mit 6 bis 16 C-Atomen oder -C₆H₅ darstellen.

11. Verwendung nach Anspruch 9 oder 10, **dadurch gekennzeichnet, dass** der Bestandteil a) aus der aus Methacrylsäureisobutylester, Acrylsäure-2-ethylhexylester, Acrylsäurecyclohexylester, Acrylsäureisobornylester, Diisobutylacrylamid, Cyclohexylacrylamid, Isobornylacrylamid, N-Acrylpiperidin und N-Methyl-N-cyclohexylacrylamid bestehenden Gruppe ausgewählt ist.

12. Verwendung nach einem der Ansprüche 9 bis 11, **dadurch gekennzeichnet, dass** der zumindest eine spaltbare Vernetzer aus Methacrylsäureanhydrid, Bis(methacryloyloxy)dimethylsilan, Bis(methacryloyloxy)tetramethyldisiloxan und Dimethylsilylen-bis(oxyethylenmethacrylat) ausgewählt ist.

13. Verwendung nach einem der Ansprüche 9 bis 12, **dadurch gekennzeichnet, dass** die Zusammensetzung zu einem in organischen Lösungsmitteln löslichen festen Polymermaterial aushärtbar ist.

14. Verwendung nach einem der Ansprüche 9 bis 13, **dadurch gekennzeichnet, dass** die Zusammensetzung zu einem säure- oder basenspaltbaren Polymermaterial aushärtbar ist.

15. Verwendung nach einem der Ansprüche 9 bis 14, **dadurch gekennzeichnet, dass** die Zusammensetzung zu einem Polymermaterial aushärtbar ist, das, gegebenenfalls nach erfolgter chemischer Spaltung zumindest einer Bindung des zumindest einen spaltbaren Vernetzers, schmelzbar ist.

## Claims

1. A method for producing three-dimensional objects, comprising producing a three-dimensional structure by sequential selective curing of layers of a composition curable with visible and/or ultraviolet light into a solid polymeric material by sequential exposure of the individual layers to UV and/or visible light, whereafter a three-dimensional object is produced by use of the three-dimensional structure thus formed, followed by removing the three-dimensional structure from or out of the three-dimensional object, wherein
the removal of the three-dimensional structure is accomplished by chemically cleaving the polymeric material and, simultaneously or subsequently, dissolving the material in a solvent or mixed solvent and/or melting the material.

2. The method according to claim 1, **characterized in that** the three-dimensional structure is used as an original mold for producing a casting mold by introducing the three-dimensional structure into a molding material and/or introducing a molding material therein, followed by curing to provide the casting mold and removing the original mold by chemically cleaving as well as dissolving and/or melting the material, whereafter the three-dimensional object is cast in the casting mold and cured.

3. The method according to claim 1, **characterized in that** the three-dimensional structure is used as a casting mold in which the three-dimensional object is cast and cured, followed by removing the casting mold by chemically cleaving and dissolving and/or melting the material.

4. The method according to any one of claims 1 to 3, **characterized in that** the material is dissolved and the solvent is selected from the group consisting of tetrahydrofuran, dioxane, ethyl acetate, toluene, and mixtures of two or more of these solvents.

5. The method according to any of the preceding claims, **characterized in that** a substantially anhydrous solvent is used.

6. The method according to any of the preceding claims, **characterized in that** the chemical cleaving of the plastic material is accomplished by use of at least one acid or base.

7. The method according to claim 6, **characterized in that** the base is selected from the group consisting of butylamine, hexylamine, octylamine, and mixtures of two or more of these bases.

8. The method according to claim 6, **characterized in that** the acid is selected from the group consisting of formic acid, acetic acid, methanesulfonic acid, and mixtures of two or more of these acids.

9. A use of a composition curable with visible and/or ultraviolet light into a solid polymeric material in a method for producing three-dimensional objects according to any of claims 1 to 8, said composition comprising:
a) 20 to 90 % by weight of at least one compound of the general formula
**CH₂=C(R')-X**
wherein
R' is hydrogen or a CH₃ group,
X represents -CO-OR¹, -CONR¹R², -O-CO-R¹, -OR¹, -C₆H₅, or -Z-R-Y,
wherein R¹ and R² independently represent branched alkyl radicals having 3 to 20 C atoms; 6- to 10-membered cycloaliphatic radicals which may be substituted with one or more linear or branched alkyl groups and which may contain one or more heteroatoms, preferably one, two or three heteroatoms, as ring members; cycloaliphatic radicals having 6 to 20 C atoms, bridged with at least one linear or branched alkylene group; or aromatic radicals having 6 to 30 C atoms,
Z represents -CO-O- or -CO-NH-,
R represents a linear or branched alkylene radical having 1 to 20 C atoms; a cycloaliphatic radical having 6 to 10 C atoms; or an aromatic radical having 6 to 30 C atoms, and
Y represents -NR¹R², -O-CO-NR¹R², -NH-CO-OR¹, -NH-CO-R¹, -O-CO-R¹, -CO-OR¹, -CO-NHR¹, or -OR¹;
b) 5 to 50 % by weight of at least one cleavable crosslinker;
c) 0,01 to 5 % by weight of at least one initiator;
d) 0 to 5 % by weight of at least one co-initiator; and
e) 0 to 70 % by weight of one or more additives, selected from the group consisting of fillers, stabilizers, viscosity modifiers, and solvents.

10. The use according to claim 9, **characterized in that**, in constituent a), X represents -CO-OR¹ or -CONR¹R², wherein R¹ and R² independently represent branched alkyl radicals having 3 to 10 C atoms; 6- to 10-membered cycloaliphatic radicals which may contain one or more heteroatoms, preferably one or two heteroatoms, as ring members; cycloaliphatic radicals having 6 to 16 C atoms, bridged with at least one linear or branched alkylene group; or -C₆H₅.

11. The use according to claim 9 or 10, **characterized in that** constituent a) is selected from the group consisting of isobutyl methacrylate, 2-ethylhexyl acrylate, cyclohexyl acrylate, isobornyl acrylate, diisobutylacrylamide, cyclohexylacrylamide, isobornylacrylamide, N-acrylpiperidine, and N-methyl-N-cyclohexylacrylamide.

12. The use according to any one of claims 9 to 11, **characterized in that** the at least one cleavable crosslinker is selected from methacrylic anhydride, bis(methacryloyloxy)dimethylsilane, bis(methacryloyloxy)tetramethyldisiloxane, and dimethylsilylen-bis(oxyethylene methacrylate).

13. The use according to any one of claims 9 to 12, **characterized in that** the composition is curable into a solid polymeric material soluble in organic solvents.

14. The use according to any one of claims 9 to 13, **characterized in that** the composition is curable into an acid- or base-cleavable polymeric material.

15. The use according to any one of claims 9 to 14, **characterized in that** the composition is curable to a polymeric material that, optionally after chemically cleaving at least one bond of the at least one cleavable crosslinker, is meltable.

## Revendications

1. Un procédé de préparation d'objets tridimensionnels, ledit procédé comportant la préparation d'une structure tridimensionnelle par le durcissement sélectif consécutif de couches d'une composition durcissable à la lumière visible et/ou ultraviolette pour former un matériau polymère solide en exposant la couche respective à la lumière visible et/ou ultraviolette, après quoi, en utilisant la structure tridimensionnelle préparée ainsi, un objet tridimensionnel est préparé, suivi de l'élimination de la structure tridimensionnelle de l'objet tridimensionnel, ladite élimination de la structure tridimensionnelle étant accomplie par le clivage chimique dudit matériau polymère et, simultanément ou consécutivement, la dissolution du matériau dans un solvant ou un mélange de solvants et/ou la fusion du matériau.

2. Le procédé selon la revendication 1, **caractérisé en ce que** la structure tridimensionnelle est utilisée comme moule original pour la préparation d'un moule par l'introduction de ladite structure tridimensionnelle dans un matériau de moulage et/ou par l'introduction d'un matériau de moulage dans ladite structure, et par l'élimination dudit matériau de moulage par dissolution et/ou fusion après son solidification, après quoi l'objet tridimensionnel est moulé et solidifié dans ladite moule.

3. Le procédé selon la revendication 1, **caractérisé en ce que** la structure tridimensionnelle est utilisée comme moule, dans laquelle l'objet tridimensionnel est moulé et solidifié, après quoi la moule est eliminée par le clivage chimique ainsi que la dissolution et/ou la fusion dudit matériau.

4. Le procédé selon l'une des revendications 1 à 3, **caractérisé en ce que** le matériau est dissous et que le solvant est sélectionné parmi le tétrahydrofurane, le dioxane, l'acétate d'éthyle, le toluène et les mélanges de deux ou plusieurs de ces solvants.

5. Le procédé selon l'une des revendications précédentes, **caractérisé en ce qu'**un solvant essentiellement non aqueux est utilisé.

6. Le procédé selon l'une des revendications précédentes, **caractérisé en ce que** le clivage chimique de la matière plastique est accompli en utilisant au moins un acide ou une base.

7. Le procédé selon la revendication 6, **caractérisé en ce que** la base est sélectionnée parmi la butylamine, l'hexylamine, l'octylamine et les mélanges de deux ou plusieurs de ces bases.

8. Le procédé selon la revendication 6, **caractérisé en ce que** l'acide est sélectionné parmi l'acide formique, l'acide acétique, l'acide méthanesulfonique et les mélanges de deux ou plusieurs de ces acides.

9. Une utilisation d'une composition durcissable à la lumière visible et/ou ultraviolette pour former un matériau polymère solide dans le procédé de préparation d'objets tridimensionnels selon l'une des revendications 1 à 8, ladite composition comprenant:
a) 20 à 90 % en poids d'au moins un composé de la formule générale
**CH₂=C(R')-X**
dans laquelle
R' représente l'hydrogène ou un groupe CH₃;
X représente -CO-OR¹, -CONR¹R², -O-CO-R¹, -OR¹, -C₆H₅ ou -Z-R-Y,
dans lesquels R¹ et R², chacun indépendamment, représentent un radical alkyle de 3 à 20 atomes de carbone; un radical cycloaliphatique à 6 à 10 chaînons qui est éventuellement substitué avec un ou plusieurs groupes alkyles linéaires ou ramifiés et qui comporte un ou plusieurs, de préférence un, deux ou trois, hétéroatomes parmi ses chaînons; un radical cycloaliphatique à 6 à 20 atomes de carbone qui est ponté avec au moins un groupe alkyle linéaire ou ramifié; ou un radical aromatique à 6 à 30 atomes de carbone,
Z représente -CO-O- ou -CO-NH-,
R représente un radical alkyle linéaire ou ramifié à 1 à 20 atomes de carbone; un radical cycloaliphatique à 6 à 10 atomes de carbone ou un radical aromatique à 6 à 30 atomes de carbone et
Y représente -NR¹R², -O-CO-NR¹R², -NH-CO-OR¹, -NH-CO-R¹, -O-CO-R¹, -CO-OR¹, -CO-NHR¹ ou -OR¹;
b) 5 à 50 % en poids d'au moins un agent de réticulation clivable;
c) 0,01 à 5 % en poids d'au moins un initiateur;
d) 0 à 5 % en poids d'au moins un co-initiateur;
e) 0 à 70 % en poids d'un ou plusieurs additifs sélectionnés parmi les matières de charge, les stabilisants, les agents modifiant la viscosité et les solvants.

10. L'utilisation selon la revendication 9, **caractérisée en ce que** X dans le composant a) représente -CO-OR¹ or -CONR¹R², dans lesquels R¹ et R², chacun indépendamment, représentent un radical alkyle de 3 à 10 atomes de carbone; un radical cycloaliphatique à 6 à 10 chaînons qui éventuellement comporte un ou plusieurs, de préférence un ou deux, hétéroatomes parmi ses chaînons; un radical cycloaliphatique à 6 à 16 atomes de carbone qui est ponté avec au moins un groupe alkyle linéaire ou ramifié; ou -C₆H₅.

11. L'utilisation selon la revendication 9 ou 10, **caractérisée en ce que** le composant a) est sélectionné parmi le méthacrylate d'isobutyle, l'acrylate de 2-éthylhexyle, l'acrylate de cyclohexyle, l'acrylate d'isobornyle, le diisobutylacrylamide, le cyclohexylacrylamide, l'isobornylacrylamide, la N-acrylpipéridine et le N-méthyl-N-cyclohexylacrylamide.

12. L'utilisation selon l'une des revendications 9 à 11, **caractérisée en ce que** ledit au moins un agent de réticulation est sélectionné parmi l'anhydride méthacrylique, le bis(méthacryloxy)diméthylsilane, le bis(méthacryloxy)tétraméthyldisiloxane et le diméthylsilylène-bis(oxyéthylèneméthacrylate).

13. L'utilisation selon l'une des revendications 9 à 12, **caractérisée en ce que** la composition est durcissable pour former un matériau polymère solide dissoluble dans un solvant organique.

14. L'utilisation selon l'une des revendications 9 à 13, **caractérisée en ce que** la composition est durcissable pour former un matériau polymère clivable par un acide ou une base.

15. L'utilisation selon l'une des revendications 9 à 14, **caractérisée en ce que** la composition est durcissable pour former un matériau polymère qui, éventuellement après le clivage chimique d'au moins une liaison dudit au moins un agent de réticulation clivable, est fusible.
